# EUROPEAN PATENT APPLICATION

(11) **EP 3 930 431 A1**
(43) Date of publication of application: **29.12.2021**
(21) Application number: 20786729.2
(22) Date of filing: 24.03.2020
(51) Int. Cl.: H05K 5/02, B44F 1/04

(54) **ELECTRONIC DEVICE HOUSING, PREPARATION METHOD THEREFOR AND ELECTRONIC DEVICE THEREWITH**

(30) Priority: 10.04.2019 CN 201910282817
(71) Applicant: GUANGDONG OPPO MOBILE TELECOMMUNICATIONS CORP., LTD., Dongguan, Guangdong 523860 (CN)
(72) Inventor: JIA, Yuhu, Dongguan, Guangdong 523860 (CN)
(74) Representative: Manitz Finsterwald Patent- und Rechtsanwaltspartnerschaft mbB
(86) International application number: PCT/CN2020/080974
(87) International publication number: WO 2020/207241

(57) **Abstract**

Provided are an electronic device housing, a preparation method therefor and an electronic device therewith. The electronic device housing comprises a housing body and an image-text layer, wherein the housing body is provided with a first surface and a second surface which are opposite each other, the first surface is provided with a first area and a second area which are adjacent to each other, the second area is located on the periphery of the first area, and the surface roughness of the second area is greater than that of the first area; and the image-text layer is arranged on the first surface, and an orthographic projection of the image-text layer on the first surface coincides with the first area.

## Description

### CROSS-REFERENCE TO RELATED APPLICATION

This application claims priority to and benefits of Chinese Patent Application Serial No. 201910282817.5, filed with the National Intellectual Property Administration of P. R. China on April 10, 2019, the entire content of which is incorporated herein by reference.

### FIELD

The present disclosure relates to a field of electronic devices, and more particularly to a housing for an electronic device, a method for manufacturing a housing for an electronic device and an electronic device.

### BACKGROUND

In the present, some identification information or decoration patterns are usually provided on an outer surface of a housing for an electronic device. However, shadows are likely to appear around the identification information or the decoration patterns, which cause a poor appearance of the identification information or the decoration patterns, and impact the user experience.

Therefore, there is still a need to further improve the related technology of the housing for the electronic device.

### SUMMARY

The present disclosure seeks to solve at least one of the problems existing in the related art to at least some extent.

The present disclosure is achieved based on the following findings and recognitions of the inventor.

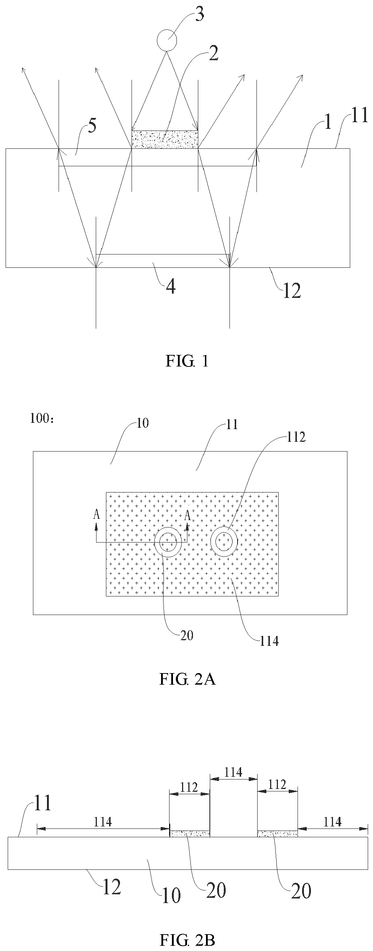

In a related art, after forming a logo layer on a housing for an electronic device, shadows will be generated around the logo layer during actual use, resulting in some problems such as the logo has a hazy and blurred boundary when a user views the logo layer, and thus degrading the user's experience. The applicant studies the above-mentioned problems, and finds the reason for the generation of the shadows. FIG. 1 shows the specific principle. The housing body 1 has a certain transmittance, and the logo layer 2 produces a projection 4 when being illuminated by a light source 3. The projection 4 is reflected by a bottom surface 12 of the housing body, and then returns to a top surface 11 of the housing body to generate shadows 5. Based on the findings, the inventor proposes that reflection conditions of and around the logo layer may be changed to undermine the foundation of optical conditions for generating shadows, that is, to solve fundamentally the problem of generating shadows.

Accordingly, an object of the present disclosure is to provide a housing for an electronic device, a method for manufacturing a housing for an electronic device and an electronic device, which have a logo layer without shadows, and have a good appearance.

In a first aspect of the present disclosure, a housing for an electronic device is provided. According to an embodiment of the present disclosure, the housing for the electronic device includes a body and a logo layer. The body has a first surface and a second surface opposite to each other, the first surface has a first area and a second area adjacent to each other, the second area is located in a periphery of the first area, and a surface roughness of the second area is greater than that of the first area. The logo layer is located on the first surface, and an orthographic projection of the logo layer on the first surface overlaps with the first area. In the housing for the electronic device, the surface roughness of the second area is greater than that of the first area to allow more diffuse reflections to happen on the second area compared with the first area when an external light irradiates the first surface, which greatly weakens an imaging ability of the light irradiated on the second area, and effectively eliminates a shadow effect. A user may view a clear logo layer with a clear boundary, and the appearance of the housing for the electronic device is significantly improved.

In a second aspect of the present disclosure, a method for manufacturing a housing for an electronic device is provided. According to an embodiment of the present disclosure, the method includes: forming a logo layer on a first surface of a body of the housing, in which the first surface has a first area and a second area adjacent to each other, an orthographic projection of the logo layer on the first surface overlaps with the first area, and the second area is located in a periphery of the first area; and roughening the second area. By the present method, the housing for the electronic device with a good appearance may be manufactured conveniently and quickly. The method has less operations and is easy to operate, and thus is suitable for industrial production. In addition, more diffuse reflections may happen on the second area compared with the first area when the external light irradiates the first surface, which greatly weakens the imaging ability of the light irradiated to the second area, and effectively eliminates the shadow effect. A user may view a clear logo layer with a clear boundary, and the appearance of the housing for the electronic device is significantly improved.

In a third aspect of the present disclosure, an electronic device is provided. According to an embodiment of the present disclosure, the electronic device includes a housing defining an accommodation space and a display screen located in the accommodation space. A light-emitting surface of the display screen faces away from the housing. The housing includes a body and a logo layer. The body has a first surface and a second surface opposite to each other, the first surface faces away from the accommodation space and has a first area and a second area adjacent to each other, the second area is located in a periphery of the first area, and a surface roughness of the second area is greater than that of the first area. The logo layer is located on the first surface, and an orthographic projection of the logo layer on the first surface overlaps with the first area. The housing for the electronic device may effectively eliminate the shadow effect. A user may view a clear logo layer with a clear boundary, and the appearance of the housing for the electronic device is significantly improved.

### BRIEF DESCRIPTION OF THE DRAWINGS

FIG. 1 is a schematic diagram showing shadows generated in a related art.
FIG. 2A is a schematic diagram showing a planar structure of a housing for an electronic device according to an embodiment of the present disclosure.
Fig. 2B is a schematic diagram showing a cross-sectional structure along a line A-A in FIG. 2A.
FIG. 3 is a schematic diagram showing a cross-sectional structure of a housing for an electronic device according to an embodiment of the present disclosure.
FIG. 4 is a flowchart of a method for manufacturing a housing for an electronic device according to an embodiment of the present disclosure.
FIG. 5 is a schematic diagram showing operations of a method for manufacturing a housing for an electronic device according to another embodiment of the present disclosure.
FIG. 6 is a flowchart of a method for manufacturing a housing for an electronic device according to still another embodiment of the present disclosure.
FIG. 7 is a schematic diagram showing an electronic device according to an embodiment of the present disclosure.
FIG. 8 is a photograph of a logo layer of a housing obtained in Example 1 of the present disclosure.
FIG. 9 is a photograph of a logo layer of a housing obtained in Comparative Example 1 of the present disclosure.

### DETAILED DESCRIPTION

The embodiments of the present disclosure are described in detail below. The embodiments described below are exemplary, and are only used to explain the present disclosure, and cannot be understood as a limitation to the present disclosure. The specific techniques or conditions not indicated in the examples shall be carried out in accordance with the techniques or conditions described in literature in the art or in accordance with the product specification.

In a first aspect of the present disclosure, a housing for an electronic device is provided. As shown in FIG. 2A and FIG. 2B, the housing for the electronic device 100 provided in an embodiment of the present disclosure includes a body 10 and a logo layer 20. The body 10 has a first surface 11 and a second surface 12 opposite to each other, the first surface 11 has a first area 112 and a second area 114 adjacent to each other, the second area 114 is located in a periphery of the first area 112, and a surface roughness of the second area 114 is greater than that of the first area 112. The logo layer 20 is located on the first surface 11, and an orthographic projection of the logo layer 20 on the first surface 11 overlaps with the first area 112. In the housing for the electronic device, the surface roughness of the second area is greater than that of the first area to allow more diffuse reflections to happen on the second area compared with the first area when an external light irradiates the first surface, which greatly weakens an imaging ability of the light irradiated on the second area, and effectively eliminates a shadow effect. A user may view a clear logo layer with a clear boundary, and the appearance of the housing for the electronic device is significantly improved.

In the description of the present disclosure, it should be understood, that terms such as "first" and "second" are used herein for purposes of description and are not intended to indicate or imply relative importance or significance or to imply the number of indicated technical features. Thus, the features defined with "first" and "second" may explicitly or implicitly include one or more of these features. In addition, the expression "the second area is located in a periphery of the first area" in the present disclosure refers to an area away from any edge position of the first area. When the edge line of the first area is a line of which an end is connected to the other end, the periphery of the first area refers to an area away from the edge line of the first area. In another case, the edge line of the first area cannot form the line of which an end is connected to the other end. For example, a first area is in a shape of a circular ring as shown in FIG 2A, and the circular ring has two edge lines, i.e., an outer edge line and an inner edge line. In this case, these two edge lines cannot form one line of which an end is connected to the other end, and thus the periphery of the first area refers to an area away from an outer edge line of the circular ring of the first area, and an area away from an inner edge line of the circular ring of the first area. It should be understood that FIG. 2A is only an exemplary illustration of the structure and shape of the housing for the electronic device of the present disclosure, and cannot be understood as a restriction for the present disclosure. Other alternative structures and shapes are also within the scope of the present disclosure.

If the body has a large transmittance, an amount of a light reflected for generating shadows is less and has a weak imaging ability, and the shadow effect is relatively insignificant at this time. If the transmittance of the body is small, an amount of a light passing through the first surface on the body is less. The light reflected by the second surface of the body for generating shadows is less, and the shadow effect is relatively insignificant. If the transmittance of the body is not particularly large or small, there will be a certain amount of light for generating shadows, and the appearance will be affected. For example, the transmittance of the body may be in a range of 2% to 50%, specifically in a range of 2% to 20%. For example, the transmittance of the body may be 2%, 5%, 10%, 15%, 20%, 25%, 30%, 35%, 40 %, 45% or 50%. For these cases, the shadow effect may be reduced or eliminated in the present disclosure.

A material for the body may be ceramics. Specifically, the ceramics usually have a certain transmittance. When the external light irradiates the ceramic body, transmission and reflection will happen, and the shadows of the logo layer may be generated. By providing the second area with a larger surface roughness, a diffuse reflection of the external light may happen when the light irradiates the second area, to undermine the foundation of conditions for generating shadows, and effectively eliminate the shadow effect.

The surface roughness of the first area and the second area may be suitably adjusted according to actual needs. Specifically, the first area has a mirror surface. Specifically, the surface roughness Ra of the first area is less than 0.03 µm, for example, 0.03 µm, 0.025 µm, 0.02 µm, 0.015 µm, 0.012 µm, 0.01 µm, 0.006 µm. Therefore, the appearance effect of the logo layer is improved, and the user's experience is improved. Specifically, the second area has a matte surface. Specifically, the surface roughness Ra of the second area is in a range of 0.03 to 0.1 µm, for example, 0.03 µm, 0.04 µm, 0.05 µm, 0.06 µm, 0.07 µm, 0.08 µm, 0.09 µm, 0.1 µm. Therefore, the external light is diffusely reflected on the second area, and it is difficult for imaging, which effectively eliminates edge shadows, achieves an effect of matte transformation, strengthens visual impact, and improves the appearance effect.

A specific shape, size, material and color of the logo layer may be suitably selected according to actual needs. Specifically, the logo layer may be a decoration pattern layer for decorating appearance, and the specific shape may be flexibly selected according to needs, such as geometric figures, decorative lines, character patterns, animal patterns, cartoon patterns, landscape patterns and plant patterns. The logo layer may be an identification information layer, such as a manufacturer logo and a model logo. The size, material and color of the logo layer may be selected according to a size, a material and a desired appearance of the housing for the electronic device, which will not be elaborately described herein.

The logo layer may be a single-layer structure or a multi-layer structure, and the specific material for forming the logo layer may be selected according to needs. Specifically, a silver film system may be used to form the logo layer, and the silver film system includes a zirconium dioxide layer and a chromium layer stacked. The zirconium dioxide layer may have a thickness from 10 to 15 nm, for example, 10 nm, 11 nm, 12 nm, 13 nm, 14 nm or 15 nm. The chromium layer may have a thickness from 20 to 60 nm, for example, 20 nm, 25 nm, 30 nm, 35 nm, 40 nm, 45 nm, 50 nm, 55 nm or 60 nm. In addition, it is also possible to use a golden film system to form the logo layer, and the golden film system includes a first silicon dioxide layer, a titanium dioxide layer, and a second silicon dioxide layer that are stacked. The first silicon dioxide layer may have a thickness of 15 nm, the titanium dioxide layer may have a thickness of 20 nm, and the second silicon dioxide layer may have a thickness of 18 nm.

A specific shape and size of the second area may be selected according to a shape and size of the first area, as long as the second area may cover the shadow of the logo layer on the first area. The specific size may be determined according to optical parameters of the body, such as a refractive index. For example, the second area may be an area having a predetermined width in a periphery of the first area, and the predetermined width may be a theoretical width by which an area, where the light for generating the shadows irradiates, exceeds the first area. Alternatively, the second area may have a size greater than the theoretical width. Alternatively, the second area may be all the other areas on the first surface except the first area.

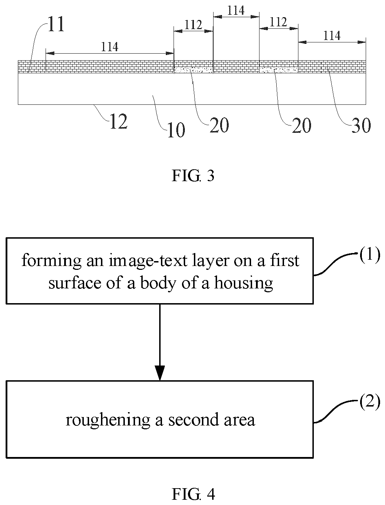

As shown in FIG 3, the housing for the electronic device may further include an anti-finger layer 30 located on the first surface 11 and covering the logo layer 20, which may improve smoothness of the housing for the electronic device, improve the user's feeling when the user touches the housing and avoid fingerprint dirt.

The anti-finger layer may be a common anti-finger layer in the art, such as a perfluoropolyether anti-finger layer with a thickness of 10 to 30 nm, for example, 10 nm, 15 nm, 20 nm, 25 nm or 30 nm. The specific process may be performed according to common technique, and will not be elaborately described herein.

In a second aspect of the present disclosure, a method for manufacturing a housing for an electronic device is provided. As shown in FIG. 4, the method in an embodiment of the present disclosure includes the following operations.

In block (1), a logo layer is formed on a first surface of a body of the housing. The first surface has a first area and a second area adjacent to each other, an orthographic projection of the logo layer on the first surface overlaps with the first area, and the second area is located in a periphery of the first area.

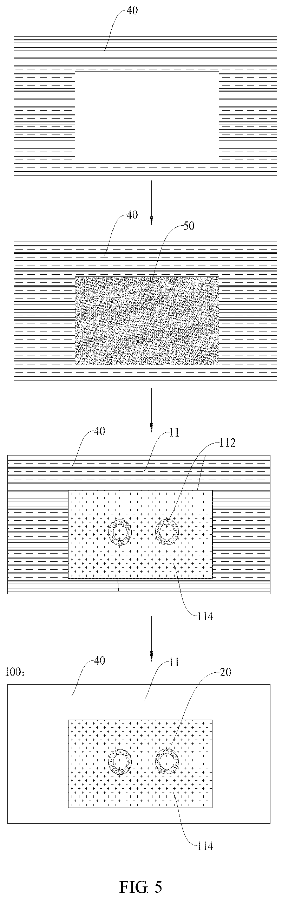

As shown in FIG 5, the formation of the logo layer includes: forming a shielding layer 40 on the first surface in which the shielding layer 40 does not cover the first area 112 and the second area 114; forming a coating layer 50 on the first area 112 and the second area 114; removing the coating layer on the second area 114, to allow the coating layer 50 on the first area 112 to form the logo layer 20; and removing the shielding layer 40.

Before the shielding layer is formed, the body may be cleaned. Specifically, the body may be subjected to ultrasonic cleaning and drying in sequence. Therefore, surface stains of the body may be effectively removed to improve cleanliness of the surface of the body and adhesion of the shielding layer.

The shielding layer may be an ink layer, and specifically may be a water-soluble ink layer. In some embodiments, a water-soluble ink layer may be silk-printed, as the shielding layer, on the first surface except the first area and the second area. A thickness of the ink layer may be in a range of 5 to 20 µm, or 8 to 15 µm, for example, 5 µm, 8 µm, 10 µm, 12 µm, 15 µm, 18 µm or 20 µm. After silk printing, baking is performed at a temperature from 100 to 150 °C, such as 100 °C, 110 °C, 120 °C, 130 °C, 140 °C or 150 °C, for 20 to 40 minutes, such as 20 minutes, 25 minutes, 30 minutes, 35 minutes or 40 minutes. Within the above-mentioned thickness range, a good shielding effect may be ensured and an economic efficiency of the processing may be improved. If the thickness is too thin, the shielding effect is relatively poor. If the thickness is too thick, energy for cutting will be increased during the processing, resulting in a high energy consumption and cost.

The coating layer may be formed by a vacuum coating process. The vacuum coating process generally refers to a process that in a vacuum equipment, a compound is evaporated at a high temperature to be adhered to a base material, achieving a molecular-level substance stacking, or a process that elemental atoms escapes from a target material by an impact of high-energy particles on the elemental target material, and the atoms meet a target gas in the vicinity of a base material to generate a compound, in which a product is controlled by adjusting a gas amount. Specifically, the body having the shielding layer may be put into the vacuum coating equipment, a film system is designed for coating according to actual needs. For example, different materials may be selected for multiple coatings to obtain the coating layer having stacked multiple layers of different materials. The specific operations and coating parameters may be referred to conventional techniques, and will not be described in detail herein.

By patterning the coating layer, the logo layer with a target shape and size may be obtained. Specifically, the coating layer may be patterned by at least one of dry etching, wet etching and laser engraving. That is, the coating layer on the second area is removed by the above-mentioned method. The specific operations and parameters may be referred to the conventional process. Specifically, the coating layer on the second area may be removed by the laser engraving, which has a better fineness, and the obtained logo layer is more refined and the appearance effect is better. Furthermore, the laser engraving is performed by a picosecond laser (a laser with a pulse width of picoseconds) due to features of a picosecond ultra-short pulse width, an adjustable repetition frequency and a high pulse energy of the picosecond laser. In this way, damage to brittle materials is less, notches and cracks are less, and the logo layer with a high precision and clear edge(s) may be obtained. A depth caused by the laser engraving may be in a range of 5 to 10 µm, such as, 5 µm, 6 µm, 7 µm, 8 µm, 9 µm or 10 µm, and thus the logo layer with a clear and good appearance may be obtained. If the depth caused by the laser engraving is too deep, the energy for cutting is increased and the production efficiency is reduced. If the depth caused by the laser engraving is too shallow, the coating film may remain and affect the appearance.

The shielding layer may be removed by peeling, etching or cleaning. Specifically, when the shielding layer is the water-soluble ink layer, the shielding layer may be removed by ultrasonic cleaning. Therefore, the operation is simple, convenient and fast, and the cost is low.

In block (2), the second area is roughened.

The second area may be roughened by at least one of sandblasting, wet etching and laser engraving. Specifically, the sandblasting includes placing sands in a sandblasting equipment and adjusting an appropriate sandblasting pressure, to allow the surface of the second area to have a suitable surface roughness. For example, the surface roughness Ra is in a range of 0.03 to 0.1 µm, such as 0.03 µm, 0.04 µm, 0.05 µm, 0.06 µm, 0.07 µm, 0.08 µm, 0.09 µm or 0.1 µm. A material of the sands includes, but is not limited to, a SiO₂ material, a SiC material, an Al₂O₃ material or any combination thereof. A mesh size of the sands may be in a range from 4000 mesh to 8000 mesh, for example, 4000 mesh, 5000 mesh, 6000 mesh, 7000 mesh or 8000 mesh. The sandblasting pressure may be in a range of 0.1 MPa to 5 MPa, for example, 0.1 MPa, 1 MPa, 2 MPa, 3 MPa, 4 MPa or 5 MPa. The wet etching may use an acidic solution containing HF to corrode the second area. A concentration of HF in the acidic solution may be in a range of 0.5%wt to 20%wt, for example, 0.5%wt, 1%wt, 2%wt, 3%wt, 4%wt, 5%wt, 6%wt, 7%wt, 8%wt, 9%wt, 10%wt, 11%wt, 12%wt, 13% wt, 14%wt, 15%wt, 16%wt, 17%wt, 18%wt, 19%wt or 20%wt. the body of the housing may be exposed to the acidic solution for a period in a range of 0.5 h to 5 h, for example, 0.5 h, 1 h, 1.5 h, 2.0 h, 2.5 h, 3.0 h, 3.5 h, 4.0 h, 4.5 h or 5.0 h.

When the laser engraving is used to remove the coating layer on the second area, due to the nature of the laser engraving, removing the coating layer on the second area and roughening the second area may be performed by the laser engraving simultaneously. That is, the laser engraving is performed for once, the coating layer on the second area is removed, and at the same time, the surface of the second area, which is subjected to the laser engraving, has a suitable roughness. A separate roughening treatment may be omitted. Therefore, the process has less operations, and thus is easy to operate and has a reduced cost.

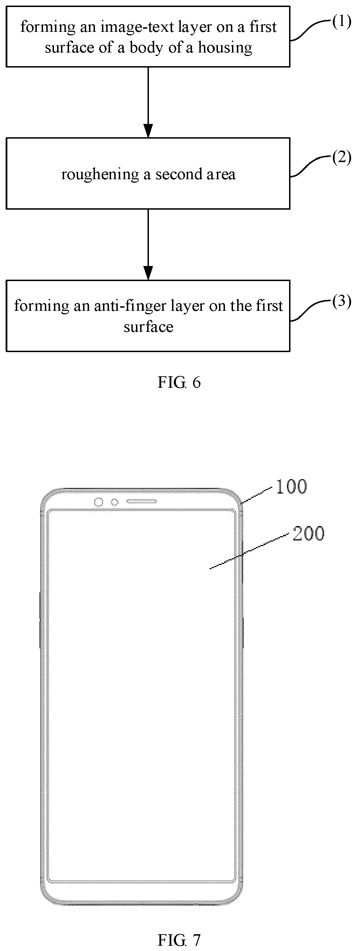

As shown in FIG. 6, the method further includes forming an anti-finger layer 30 on the first surface 11. Specifically, the anti-finger layer may be formed by a vacuum coating process. The specific operations and coating parameters may be referred to conventional techniques, and will not be described in detail herein. Before forming the anti-finger layer, a transition layer may be formed to increase a bonding strength between the anti-finger layer and the body, and to enhance wear resistance of the anti-finger layer. Specifically, the transition layer may be formed by silicon dioxide, and have a thickness of 10 to 30 nm, for example, 10 nm, 15 nm, 20 nm, 25 nm or 30 nm. The anti-finger layer may be formed on the transition layer, and have a thickness of 10 to 30 nm, for example, 10 nm, 15 nm, 20 nm, 25 nm or 30 nm. A material of the anti-finger layer may be any conventional anti-finger layer material, such as perfluoropolyether, and will not be elaborately described herein.

By the present method, the housing for the electronic device with the good appearance may be manufactured conveniently and quickly. The method has less operations and is easy to operate, and thus is suitable for industrial production. In addition, more diffuse reflections may happen on the second area compared with the first area when the external light irradiates the first surface, which greatly weakens the imaging ability of the light irradiated to the second area, and effectively eliminates the shadow effect. A user may view a clear logo layer with a clear boundary, and the appearance of the housing for the electronic device is significantly improved. The method may be used to prepare the above-mentioned housing for the electronic device. The method may be effectively used to prepare the above-mentioned housing for the electronic device.

In a third aspect of the present disclosure, an electronic device is provided. As shown in FIG. 7, the electronic device provided in an embodiment includes a housing 100 defining an accommodation space and a display screen 200 located in the accommodation space. A light-emitting surface of the display screen 200 (i.e., a surface of the display screen viewed by the user) faces away from the housing 100. As shown in FIG. 2A and FIG. 2B, the housing 100 includes a body 10 and a logo layer 20. The body 10 has a first surface 11 and a second surface 12 opposite to each other, the first surface 11 has a first area 112 and a second area 114 adjacent to each other, the second area 114 is located in a periphery of the first area 112, and a surface roughness of the second area 114 is greater than that of the first area 112. The logo layer 20 is located on the first surface 11, and an orthographic projection of the logo layer 20 on the first surface 11 overlaps with the first area 112. In the housing for the electronic device, the shadow effect may be effectively eliminated. A user may view a clear logo layer with a clear boundary, and the appearance of the housing for the electronic device is significantly improved. The housing of the electronic device may be the above-mentioned housing for the electronic device.

It should be noted that FIG. 7 shows a structure of an electronic device, for example, a mobile phone, which shall not be understood as a restriction to the present disclosure. The specific type of the electronic device includes, but is not limited to, mobile phones, laptops, tablet computers, game consoles or wearable devices. In addition to the housing and the display screen described above, the electronic device may further include structures and components necessary for a conventional electronic device. For example, the mobile phone may further include a CPU, a touch screen, a front cover, a camera module, a fingerprint module, a battery, an electro-acoustic module and other structures and components of the conventional mobile phone, and will not be described in detail herein.

Hereinafter, examples of the present disclosure are described in detail.

### Example 1

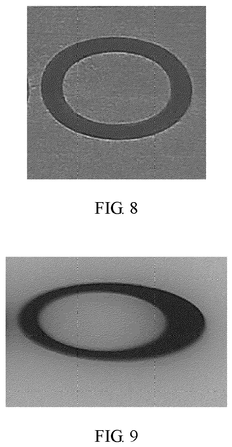

Specific manufacturing process includes the following operations.
1. A ceramic body is ultrasonic cleaned and dried to remove surface stains, to improve cleanliness of the ceramic surface, and thus improve an adhesion of a water-soluble ink.
2. A water-soluble ink layer with a thickness of 8 to 15 µm is silk-printed on the first surface of the ceramic body, and the obtained ink layer is dried at a temperature in a range of 100 to 150 °C for 20 to 40 min.
3. The ceramic body having the ink layer is placed in a vacuum coating equipment to form a golden coating layer having a structure of stacked three layer of Si02 (15nm), Ti02 (20nm) and SiO₂ (18nm) on the first area and the second area. The ceramic body having the coating layer is ultrasonic cleaned in the water to remove the water-soluble ink layer.
4. The coating layer on the second area is removed by picosecond laser engraving, to allow a part of the coating layer which is not removed to form a logo layer. A depth caused by the laser engraving is in a range of 5 to 10 µm. By controlling parameters of the laser engraving, a surface roughness Ra of the second area exposed after the laser engraving is in a range of 0.03 to 0.1 µm. No additional roughening treatment is required. That is, the laser engraving is performed for once to not only remove the coating layer from an area where the coating layer is not desired, but also to allow the first area to be a mirror surface and the second area to be a matte surface.
5. A silicon dioxide layer having a thickness of 10 to 30 nm is formed by vacuum coating as a primer layer on the first surface of the ceramic body, and an anti-finger layer (i.e., an AF film) having a thickness of 10 to 30 nm is formed by vacuum coating on a surface of the primer layer, to increase smoothness and finger dirt resistance of the housing. FIG. 8 shows a photograph of the logo layer of the housing obtained.

### Comparative Example 1

Specific manufacturing process is substantially the same as Example 1, expect that during the formation of the coating layer, the shielding layer covers the second area and does not cover the first area, the coating layer is formed only on the first area after the vacuum coating to form the logo layer, and the laser engraving is not performed. FIG. 9 shows a photograph of the logo layer of the housing obtained.

As shown in FIG. 8 and FIG. 9, by changing the surface roughness around the logo layer in the present disclosure, the specular reflection of the surrounding area (i.e., the second area) is significantly reduced, and the diffuse reflection is increased, and the edge shadow of the logo layer is effectively eliminated. The user may view a clear logo layer with a clear boundary, and the logo layer may have an effect of matte transformation, and a stronger visual impact, resulting in a better viewing experience of the user.

Reference throughout this specification to terms of "an embodiment," "some embodiments," "an example," "a specific example," or "some examples," means that a particular feature, structure, material, or characteristic described in connection with the embodiment or example is included in at least one embodiment or example of the present disclosure. In this specification, the exemplary appearances of the above-mentioned term are not necessarily referring to the same embodiment or example of the present disclosure. Furthermore, the particular features, structures, materials, or characteristics may be combined in any suitable manner in one or more embodiments or examples. In addition, the different embodiments or examples and the features of the different embodiments or examples described in this specification may be combined by those skilled in the art without contradicting each other.

Although explanatory embodiments have been shown and described, it would be appreciated by those skilled in the art that the above embodiments cannot be construed to limit the present disclosure, and changes, alternatives, and modifications can be made in the embodiments without departing from scope of the present disclosure.

## Claims

1. A housing for an electronic device, comprising:
a body, having a first surface and a second surface opposite to each other, wherein the first surface has a first area and a second area adjacent to each other, the second area is located in a periphery of the first area, and a surface roughness of the second area is greater than that of the first area; and
a logo layer, located on the first surface, wherein an orthographic projection of the logo layer on the first surface overlaps with the first area.

2. The housing according to claim 1, wherein the body has a light transmittance of 2% to 50%.

3. The housing according to claim 1 or 2, wherein the body has a light transmittance of 2% to 20%.

4. The housing according to any one of claims 1 to 3, wherein a material for the body comprises ceramics.

5. The housing according to any one of claims 1 to 4, wherein the first area has a mirror surface, and the second area has a matte surface.

6. The housing according to any one of claims 1 to 5, wherein the surface roughness Ra of the first area is less than 0.03 µm, and the surface roughness Ra of the second area is in a range of 0.03 to 0.1 µm.

7. The housing according to any one of claims 1 to 6, wherein the logo layer comprises at least one selected from a decoration pattern layer and an identification information layer.

8. The housing according to any one of claims 1 to 7, further comprising:
an anti-finger layer, located on the first surface and covering the logo layer.

9. A method for manufacturing a housing for an electronic device, comprising:
forming a logo layer on a first surface of a body of the housing, wherein the first surface has a first area and a second area adjacent to each other, an orthographic projection of the logo layer on the first surface overlaps with the first area, and the second area is located in a periphery of the first area; and
roughening the second area.

10. The method according to claim 9, wherein forming the logo layer comprises:
forming a shielding layer on the first surface, wherein the shielding layer does not cover the first area and the second area;
forming a coating layer on the first area and the second area;
removing the coating layer on the second area, to allow the coating layer on the first area to form the logo layer; and
removing the shielding layer.

11. The method according to claim 10, wherein the coating layer on the second area is removed by at least one selected from dry etching, wet etching and laser engraving.

12. The method according to claim 11, wherein removing the coating layer on the second area and roughening the second area are performed by the laser engraving in one operation.

13. The method according to claim 9, wherein roughening the second area is performed by at least one selected from blasting, wet etching and laser engraving.

14. The method according to any one of claims 11 to 13, wherein the laser engraving is picosecond laser engraving.

15. The method according to any one of claims 9 to 14, further comprising:
forming an anti-finger layer on the first surface.

16. An electronic device, comprising:
a housing, defining an accommodation space and comprising:
a body, having a first surface and a second surface opposite to each other, wherein the first surface faces away from the accommodation space and has a first area and a second area adjacent to each other, the second area is located in a periphery of the first area, and a surface roughness of the second area is greater than that of the first area; and
a logo layer, located on the first surface, wherein an orthographic projection of the logo layer on the first surface overlaps with the first area;
and
a display screen, located in the accommodation space, wherein a light-emitting surface of the display screen faces away from the housing.
